# EUROPEAN PATENT APPLICATION

(11) **EP 4 160 683 A2**
(43) Date of publication of application: **05.04.2023**
(21) Application number: 22191462.5
(22) Date of filing: 22.08.2022
(51) Int. Cl.: H01L 27/12

(54) **THIN-FILM TRANSISTOR ARRAY SUBSTRATE AND DISPLAY DEVICE**

(30) Priority: 01.10.2021 KR 20210131187
(71) Applicant: LG Display Co., Ltd., SEOUL, 07336 (KR)
(72) Inventor: JEONG, ChanYong, 10845 Paju-si, Gyeonggi-do (KR); OK, KyungChul, 10845 Paju-si, Gyeonggi-do (KR); NOH, Jiyong, 10845 Paju-si, Gyeonggi-do (KR)
(74) Representative: Viering, Jentschura & Partner mbB Patent- und Rechtsanwälte

(57) **Abstract**

A thin-film transistor array substrate and a display device (100) are disclosed. A semiconductor layer (540) includes a channel portion (543), a first conductorized portion (541) on a first side of the channel portion (543) and including a first main conductorized portion (541M) and a first sub-conductorized portion (541S), and a second conductorized portion (542) on a second side of the channel portion (543) and including a second main conductorized portion (542M) and a second sub-conductorized portion (542S). A gate insulating film (GI) is on the channel portion (543). A first auxiliary electrode (551) is on the first main conductorized portion (541M). A first electrode (510) is on the first auxiliary electrode (551). A second auxiliary electrode (552) is on the second main conductorized portion (542M). A second electrode (520) is on the second auxiliary electrode (552). A third electrode (530) is on the gate insulating film (GI) and overlapping the channel portion (543). Each of the first auxiliary electrode (551) and the second auxiliary electrode (552) contains a conductive oxide.

## Description

### CROSS REFERENCE TO RELATED APPLICATION

This application claims priority from Republic of Korea Patent Application No. 10-2021-0131187, filed on October 1, 2021.

### BACKGROUND

### Field

Embodiments relate to a thin-film transistor (TFT) array substrate and a display device.

### Description of Related Art

Transistors are widely used as switching devices or driving devices in the field of electronic devices. In particular, thin-film transistors that may be fabricated on a glass substrate or on a plastic substrate are widely used as switching devices in display devices such as liquid crystal display (LCD) devices or organic light-emitting display devices.

On the basis of the material of the semiconductor layer thereof, thin-film transistors may be categorized as amorphous silicon (a-Si) thin-film transistors in which amorphous silicon is used for a semiconductor layer, polysilicon (poly-Si) thin-film transistors in which polysilicon is used for a semiconductor layer, or oxide thin-film transistors in which oxide is used for a semiconductor layer.

Since the amorphous silicon may be deposited to form an active layer in a short period of time, a-Si thin-film transistors are advantageous in terms of a short fabrication process time and low fabrication costs. In contrast, since a-Si thin-film transistors have low current driving ability and variations in the threshold voltage due to low mobility, the use of a-Si thin-film transistors to organic light-emitting display devices is disadvantageously restricted.

Poly-Si thin-film transistors are formed by depositing amorphous silicon and then crystallizing the deposited amorphous silicon. Since the fabrication process of poly-Si thin-film transistors requires an a-Si crystallization process, the number of process steps is increased, thereby increasing fabrication cost. In addition, since the crystallization process is performed at a high processing temperature, it is difficult to use poly-Si thin-film transistors in a large-area device. Furthermore, due to poly-Si characteristics, it is difficult to obtain uniformity in poly-Si thin-film transistors.

In the case of oxide semiconductor thin-film transistors, an oxide film of an active layer may be formed at a relatively low temperature. In addition, oxide semiconductor thin-film transistors have high mobility and have significant changes in resistance depending on the content of oxygen thereof. It is advantageously easy to manufacture oxide semiconductor thin-film transistors to have required physical properties. In addition, due to an oxide characteristic, transparent oxide transistors are advantageous for realizing transparent displays. However, to use an oxide semiconductor layer in thin-film transistors, a separate conductorization process of forming connections to source and drain electrodes may be required.

### SUMMARY

In a thin-film transistor of the related art, when a gate insulating film is positioned on a semiconductor layer and a gate electrode is positioned on the gate insulating film, a source electrode and a conductorized portion of the semiconductor layer may be connected through a contact hole of the gate insulating film, and a drain electrode and the conductorized portion of the semiconductor layer may be connected. Here, in an etching process to form the contact hole of the gate insulating film, the conductorized portion of the semiconductor layer may be damaged, which is problematic. In the embodiments herein, a thin-film transistor array substrate and a display device having a thin-film transistor structure capable of preventing or at least reducing damage to the conductorized portion of the semiconductor layer.

Embodiments may provide a thin-film transistor array substrate and a display device having a thin-film transistor structure capable of preventing or at least reducing damage to the conductorized portion of the semiconductor layer and preventing or at least reducing unnecessary parasitic capacitance from being generated.

Embodiments may provide a thin-film transistor array substrate and a display device having a thin-film transistor structure capable of preventing or at least reducing damage to the conductorized portion of the semiconductor layer from being damaged and preventing or at least reducing a misalignment structure between a channel portion of the semiconductor layer and the gate electrode.

Embodiments may provide a thin-film transistor array substrate and a display device having a thin-film transistor structure capable of reducing the possibility of the surface of the channel portion of the semiconductor layer to be contaminated or damaged during processing.

Embodiments may provide a thin-film transistor array substrate and a display device including thin-film transistors in which high performance, high stability, and high reliability may be achieved. Embodiments may provide a display device according to claim 1. Further embodiments are described in the dependent claims.

In one or more embodiments, a display device comprises: a substrate; a semiconductor layer comprising a channel portion, a first conductorized portion positioned on a first side of the channel portion, and a second conductorized portion positioned on a second side of the channel portion that is opposite the first side, the first conductorized portion including a first main conductorized portion and a first sub-conductorized portion, and the second conductorized portion including a second main conductorized portion and a second sub-conductorized portion; a gate insulating film on the channel portion; a first auxiliary electrode positioned on the first main conductorized portion; a first electrode on the first auxiliary electrode; a second auxiliary electrode positioned on the second main conductorized portion; a second electrode on the second auxiliary electrode; and a third electrode positioned on the gate insulating film, the third electrode overlapping the channel portion, wherein each of the first auxiliary electrode and the second auxiliary electrode comprises a conductive oxide.

Th conductive oxide may comprise at least one of a transparent conductive oxide, a nitrogen oxide, or an organic matter.

The first sub-conductorized portion may be positioned between the first main conductorized portion and the channel portion. The second sub-conductorized portion may be positioned between the second main conductorized portion and the channel portion. A resistance of the first main conductorized portion may be less than a resistance of the first sub-conductorized portion. The resistance of the first sub-conductorized portion may be less than a resistance of the channel portion. A resistance of the second main conductorized portion may be less than a resistance of the second sub-conductorized portion. The resistance of the second sub-conductorized portion may be less than the resistance of the channel portion.

The first sub-conductorized portion may be non-overlapping with at least one of the first electrode or the third electrode. An electrical conductivity of the first sub-conductorized portion may be different from an electric conductivity of the first main conductorized portion. The second sub-conductorized portion may be non-overlapping with at least one of the second electrode or the third electrode. An electrical conductivity of the second sub-conductorized portion may be different from an electrical conductivity of the second main conductorized portion.

At least one among the first electrode, the second electrode, or the third electrode may comprise a first material layer and a second material layer, the first material layer including a first material and the second material layer including a second material that is different from the first material. Each of the first material and the second material may be different from the conductive oxide and lacks oxygen.

The display device may further comprise: a passivation layer disposed on the first electrode, the second electrode, and the third electrode. The gate insulating film may comprise a first open area that exposes the first sub-conductorized portion in the first open area and a second open area that exposes the second sub-conductorized portion in the second area such that a first portion of the passivation layer is in contact with the first sub-conductorized portion in the first open area, and a second portion of the passivation layer is in contact with the second sub-conductorized portion in the second open area. The first electrode and the first auxiliary electrode may be electrically connected in the first open area, and the second electrode and the second auxiliary electrode may be electrically connected in the second open area.

The display device may further comprise: a passivation layer disposed on the first electrode, the second electrode, and the third electrode. The gate insulating film may comprise a first open area and a second open area such that the first electrode and the first auxiliary electrode are electrically connected in the first open area, and the second electrode and the second auxiliary electrode are electrically connected in the second open area. The gate insulation film may be between the first sub-conductorized portion and the passivation layer, and the gate insulation film may be between the second sub-conductorized portion and the passivation layer.

The passivation layer may comprise a plurality of layers, each layer of the plurality of layers having a different hydrogen content from other layers of the plurality of layers.

The hydrogen content of at least one of the plurality of layers of the passivation layer may be greater than a hydrogen content of the first sub-conductorized portion and a hydrogen content of the second sub-conductorized portion.

The display device may further comprise: a functional insulating film positioned between the passivation layer and the first electrode, the second electrode, and the third electrode, the functional insulating film comprising hydrogen.

A hydrogen content of the functional insulating film may be greater than a hydrogen content of the first sub-conductorized portion and a hydrogen content of the second sub-conductorized portion.

The display device may further comprise: a buffer layer that is closer to the substrate than the semiconductor layer; and a light shield that is closer to the substrate than the buffer layer. The first electrode may be electrically connected to the light shield through a contact hole extending through the gate insulating film and the buffer layer.

The display device may further comprise: a plurality of sub-pixels, each sub-pixel comprising a driving transistor and a capacitor. The driving transistor may be a thin-film transistor comprising the first electrode, the second electrode, the third electrode, and the semiconductor layer. The capacitor may comprise a first plate, a second plate, and a third plate. The buffer layer may be positioned between the first plate and the second plate, and the gate insulating film may be positioned between the second plate and the third plate.

The first plate may be electrically connected to the first electrode or the light shield, the first plate comprises the light shield that is electrically connected to the first electrode, or the first plate comprises a metal that is contained the light shield. The third plate may be the third electrode or the first electrode, the third plate may be electrically connected to the third electrode or the first electrode, or the third plate comprises a metal positioned on the same layer as the third electrode or the first electrode. The second plate may comprise a conductive semiconductor plate and a conductive oxide plate, the conductive semiconductor plate including a semiconductor material that is the same as a semiconductor material included in the semiconductor layer, and the conductive oxide plate comprising the conductive oxide.

In one or more embodiments, a display device comprises: a substrate; a semiconductor layer on the substrate, the semiconductor layer including a channel portion, a first conductorized portion positioned on a first side of the channel portion and a second conductorized portion positioned on a second side of the channel portion that is opposite the first side, the first conductorized portion including a first main conductorized portion and a first sub-conductorized portion that has different electrical characteristics than the first main conductorized portion, and the second conductorized portion including a second main conductorized portion and a second sub-conductorized portion that has different electrical characteristics than the second main conductorized portion; a first auxiliary electrode on the first main conductorized portion, but not the first sub-conductorized portion; a first electrode on the first auxiliary electrode, the first electrode overlapping the first main conductorized portion but being non-overlapping with the first sub-conductorized portion; a second auxiliary electrode positioned on the second main conductorized portion, but not the second sub-conductorized portion; a second electrode on the second auxiliary electrode, the second electrode overlapping the second main conductorized portion but being non-overlapping with the second sub-conductorized portion; and a third electrode overlapping the channel portion.

The first auxiliary electrode and the second auxiliary electrode may each comprise a conductive oxide.

The display device may further comprising: a gate insulation film between the third electrode and the channel portion, the gate insulation film non-overlapping with the first sub-conductorized portion and the second sub-conductorized portion; and a passivation layer on the first electrode, the second electrode, and the third electrode, the passivation layer in contact with the first sub-conductorized portion and the second sub-conductorized portion.

The display device may further comprise: a gate insulation film between the third electrode and the channel portion, the gate insulation film overlapping with the first sub-conductorized portion and the second sub-conductorized portion; and a passivation layer on the first electrode, the second electrode, and the third electrode such that a first portion of the gate insulation film is between a first portion of the passivation layer and the first sub-conductorized portion, and a second portion of the gate insulation film is between a second portion of the passivation layer and the second sub-conductorized portion.

The electrical characteristics may include resistance and electrical conductivity, wherein a resistance of the first main conductorized portion maybe less than a resistance of the first sub-conductorized portion, and the resistance of the first sub-conductorized portion may be less than a resistance of the channel portion, and a resistance of the second main conductorized portion may be less than a resistance of the second sub-conductorized portion, and the resistance of the second sub-conductorized portion may be less than the resistance of the channel portion, wherein an electrical conductivity of the first sub-conductorized portion may be different from an electric conductivity of the first main conductorized portion, and an electrical conductivity of the second sub-conductorized portion may be different from an electrical conductivity of the second main conductorized portion.

The display device may further comprise: a light-emitting element configured to emit light, wherein the semiconductor layer, the first auxiliary electrode, the first electrode, the second auxiliary electrode, the second electrode, and the third electrode may be included in a transistor that is electrically connected to the light-emitting element.

### DESCRIPTION OF DRAWINGS

The above and other objectives, features, and advantages of the present disclosure will be more clearly understood from the following detailed description, taken in conjunction with the accompanying drawings, in which:
FIG. 1 is a diagram illustrating a configuration of a display device according to one embodiment;
FIG. 2 illustrates an equivalent circuit of a subpixel of the display device according to one embodiment;
FIG. 3 illustrates another equivalent circuit of a subpixel of the display device according to one embodiment;
FIG. 4 is a diagram illustrating a light shield in a subpixel of the display device according to one embodiment;
FIG. 5 is a cross-sectional diagram illustrating a vertical structure of a thin-film transistor in the display device according to one embodiment;
FIG. 6 is a cross-sectional diagram illustrating a thin-film transistor having a gate insulating film etch structure in the display device according to one embodiment;
FIG. 7 is a cross-sectional diagram illustrating a driving transistor in which the thin-film transistor illustrated in FIG. 6 is used according to one embodiment;
FIG. 8 is a cross-sectional diagram illustrating a thin-film transistor having a gate insulating film etchless structure in the display device according to one embodiment;
FIG. 9 is a cross-sectional diagram illustrating a driving transistor in which the thin-film transistor illustrated in FIG. 8 is used according to one embodiment;
FIG. 10 is a cross-sectional view illustrating a thin-film transistor having a gate insulating film etchless structure and a hydrogen supply structure in the display device according to one embodiment;
FIG. 11 is a cross-sectional view illustrating a capacitor structure of the display device according to one embodiment; and
FIG. 12 is a graph illustrating electrical characteristics of the thin-film transistor of the display device according to the embodiments, in which a drain current changes with changes in a gate voltage.

### DETAILED DESCRIPTION

In the following description of examples or embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "made up of', and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements etc., but is used merely to distinguish the corresponding element from other elements.

When it is mentioned that a first element "is connected or coupled to", "contacts or overlaps" etc. a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc. each other via a fourth element. Here, the second element may be included in at least one of two or more elements that "are connected or coupled to", "contact or overlap", etc. each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

In addition, when any dimensions, relative sizes etc. are mentioned, it should be considered that numerical values for an elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can".

Hereinafter, a variety of embodiments will be described with reference to the accompanying drawings.

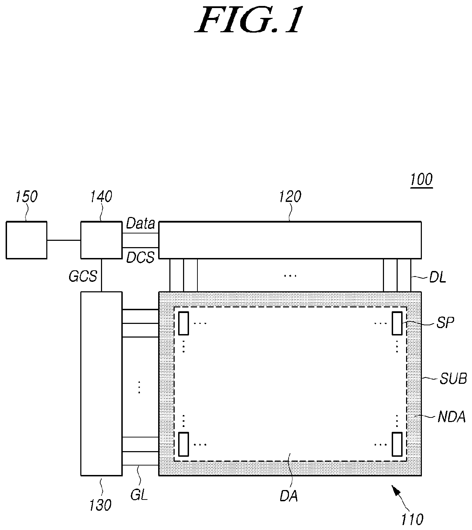

FIG. 1 is a diagram illustrating a configuration of a display device 100 according to embodiments.

Referring to FIG. 1, the display device 100 according to embodiments may include a display panel 110 and a driver circuit driving the display panel 110.

The driver circuit may include a data driver circuit 120, a gate driver circuit 130, and the like. The driver circuit may further include a controller 140 controlling the data driver circuit 120 and the gate driver circuit 130.

The display panel 110 may include a substrate SUB and signal lines, such as a plurality of data lines DL and a plurality of gate lines GL, disposed on the substrate SUB. The display panel 110 may include a plurality of subpixels SP connected to the plurality of data lines DL and the plurality of gate lines GL.

The display panel 110 may include a display area DA on which images are displayed and a non-display area NDA on which images are not displayed. In the display panel 110, the plurality of subpixels SP for displaying images are disposed in the display area DA. In the non-display area NDA, a pad part to which the driver circuits 120, 130, and 140 are electrically connected, on which on the driver circuits 120, 130, and 140 are mounted, or to which integrated circuits or a printing circuit are connected may be disposed.

The data driver circuit 120 is a circuit driving the plurality of data lines DL, and may provide data signals to the plurality of data lines DL. The controller 140 may provide control signals DCS to the data driver circuit 120 to control the operation timing of the data driver circuit 120. The controller 140 may provide gate control signals GCS to the gate driver circuit 130 to control the operation timing of the gate driver circuit 130.

The controller 140 may start scanning at points in time defined for respective frames, convert image data input from an external source into image data Data having a data signal format readable by the data driver circuit 120, provide the image data Data to the data driver circuit 120, and control data driving at appropriate points in time in response to the scanning.

The controller 140 may output a variety of gate control signals GCS including a gate start pulse (GSP) signal, a gate shift clock (GSC) signal, a gate output enable (GOE) signal, and the like in order to control the gate driver circuit 130.

The controller 140 may output a variety of data control signals DCS including a source start pulse (SSP) signal, a source sampling clock (SSC), a source output enable (SOE) signal, and the like in order to control the data driver circuit 120.

The controller 140 may be provided as a component separate from the data driver circuit 120 or may be combined with the data driver circuit 120 to form an integrated circuit (IC).

The data driver circuit 120 drives the plurality of data lines DL by receiving the image data Data from the controller 140 and supplying a data voltage to the plurality of data lines DL. Herein, the data driver circuit 120 is also referred to as a source driver circuit.

The data driver circuit 120 may include one or more source driver integrated circuit (SDIC).

For example, each of the SDICs may be connected to the display panel 110 by a tape-automated bonding (TAB) method, connected to a bonding pad of the display panel 110 by a chip-on-glass (COG) method or a chip on panel (COP) method, or implemented using a chip-on-film (COF) structure connected to the display panel 110.

The gate driver circuit 130 may output gate signals having a turn-on level or a turn-off level, under the control of the controller 140. The gate driver circuit 130 may sequentially drive the plurality of gate lines GL by sequentially providing gate signals having a turn-on level or a turn-off level to the plurality of gate lines GL.

The gate driver circuit 130 may be connected to the display panel 110 by a TAB method, connected to a bonding pad of the display panel 110 by a COG method or a COP method, or connected to the display panel 110 by a COF method. Alternatively, the gate driver circuit 130 may be formed in the non-display area NDA of the display panel 110 by a gate-in-panel (GIP) method. The gate driver circuit 130 may be disposed on the substrate SUB or connected to the substrate SUB. That is, when the gate driver circuit 130 is a GIP type, the gate driver circuit 130 may be disposed in the non-display area NDA of the substrate SUB. When the gate driver circuit 130 is a COG type, a COF type, or the like, the gate driver circuit 130 may be connected to the substrate SUB.

In addition, at least one driver circuit of the data driver circuit 120 and the gate driver circuit 130 may be disposed in the display area DA. For example, at least one driver circuit of the data driver circuit 120 and the gate driver circuit 130 may be disposed to not overlap the subpixels SP or to overlap a portion or the entirety of the subpixels SP.

When a specific gate line GL among the plurality of gate lines GL is opened by the gate driver circuit 130, the data driver circuit 120 may convert the image data Data received from the controller 140 into an analog voltage and supply the analog voltage to the plurality of data lines DL.

The data driver circuit 120 may be connected to one side (e.g., a top side or a bottom side) of the display panel 110. The data driver circuit 120 may be connected to both sides (e.g., both the top side and the bottom side) of the display panel 110 or connected to two or more sides among a plurality of sides (e.g., four sides) of the of the display panel 110, depending on the driving method, the design of the display panel, or the like.

The gate driver circuit 130 may be connected to one side (e.g., a left side or a right side) of the display panel 110. The gate driver circuit 130 may be connected to both sides (e.g., both the left side and the right side) of the display panel 110 or connected to two or more sides among the plurality of sides of the of the display panel 110, depending on the driving method, the design of the display panel, or the like.

The controller 140 may be a timing controller used in typical display field, may be a control device including a timing controller and able to perform other control functions, may be a control device different from the timing controller, or may be a circuit in a control device. The controller 140 may be implemented as a variety of circuits or electronic components, such as an integrated circuit (IC), a field programmable gate array (FPGA), an application specific integrated circuit (ASIC), a processor, or the like.

The controller 140 may be mounted on a printed circuit board (PCB), a flexible printed circuit (FPC), or the like, and electrically connected to the data driver circuit 120 and the gate driver circuit 13 through the PCB, the FPC, or the like.

The display device 100 according to the present embodiments may be a display, such as a liquid crystal display device, including a backlight unit or may be a self-emissive display, such as an organic light-emitting diode (OLED) display, a quantum dot display, or a micro light-emitting diode (LED) display.

When the display device 100 according to the present embodiments is an OLED display, each of the subpixels SP may include a self-emissive OLED as an emitting device. When the display device 100 is a quantum dot display, each of the subpixels SP may include an emitting device implemented as a quantum dot that is a self-emissive semiconductor crystal. When the display device 100 according to the present embodiments is a micro LED display, each of the subpixels SP may include, as an emitting device, a self-emissive micro LED formed on the basis of an inorganic material.

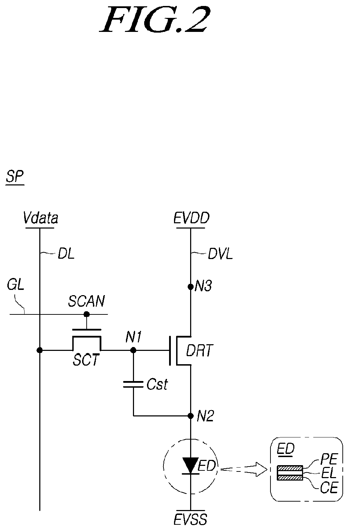

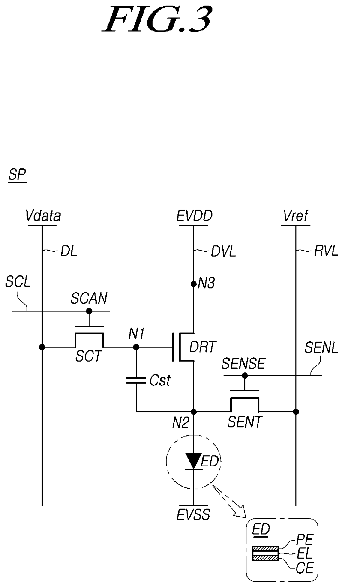

FIG. 2 illustrates an equivalent circuit of a subpixel SP of the display device 100 according to an embodiment, and FIG. 3 illustrates another equivalent circuit of a subpixel SP of the display device 100 according to an embodiment.

Referring to FIG. 2, each of the plurality of subpixels SP disposed in the display panel 110 of the display device 100 according to embodiments may include an emitting device ED, a driving transistor DRT, a scan transistor SCT, and a storage capacitor Cst.

Referring to FIG. 2, the emitting device ED may include a pixel electrode PE, a common electrode CE, and an emissive layer EL positioned between the pixel electrode PE and the common electrode CE.

The pixel electrode PE of the emitting device ED may be an electrode disposed on each of the subpixels SP, and the common electrode CE may be an electrode commonly disposed on all of the subpixels SP. Here, the pixel electrode PE may be an anode, and the common electrode CE may be a cathode. Alternatively, the pixel electrode PE may be a cathode, and the common electrode CE may be an anode.

For example, the emitting device ED may be an organic light-emitting diode (OLED), a light-emitting diode (LED), or a quantum dot emitting device.

The driving transistor DRT is a transistor for driving the light emitting device ED, and may include a first node N1, a second node N2, a third node N3, and the like.

The first node N1 of the driving transistor DRT may be a gate node of the driving transistor DRT, and electrically connected to a source node or a drain node of the scan transistor SCT. The second node N2 of the driving transistor DRT may be a source node or a drain node of the driving transistor DRT, electrically connected to a source node or a drain node of a sensing transistor SENT, and electrically connected to the pixel electrode PE of the emitting device ED. The third node N3 of the driving transistor DRT may be electrically connected to a driving voltage line DVL through which a driving voltage EVDD is supplied.

The scan transistor SCT may be controlled by a scan signal SCAN that is a type of gate signal, and connected to the first node N1 of the driving transistor DRT and a data line DL. That is, the scan transistor SCT may be turned on or off by the scan signal SCAN supplied through a scan signal line SCL that is a type of gate line GL, and control the connection between the data line DL and the first node N1 of the driving transistor DRT.

The scan transistor SCT may be turned on by the scan signal SCAN having a turn-on level voltage to transfer a data voltage Vdata supplied through the data line DL to the first node N1 of the driving transistor DRT.

Here, when the scan transistor SCT is an N-type transistor, the turn-on level voltage of the scan signal SCAN may be a high level voltage. When the scan transistor SCT is a P-type transistor, the turn-on level voltage of the scan signal SCAN may be a low level voltage.

The storage capacitor Cst may be connected to the first node N1 and the second node N2 of the driving transistor DRT. The storage capacitor Cst is charged with an amount of electric charge corresponding to the voltage difference between both ends of the storage capacitor Cst, and serves to maintain the voltage difference between the ends for a predetermined frame time. Thus, for the predetermined frame time, the corresponding subpixel SP may emit light.

Referring to FIG. 3, each of the plurality of subpixels SP disposed in the display panel 110 of the display device 100 according to the present embodiments may further include the sensing transistor SENT.

The sensing transistor SENT may be controlled by a sense signal SENSE that is a type of gate signal, and connected to the second node N2 of the driving transistor DRT and a reference voltage line RVL. In other words, the sensing transistor SENT may be turned on or off by the sense signal SENSE supplied through a sense signal line SENL that is a type of gate line GL to control the connection between the reference voltage line RVL and the second node N2 of the driving transistor DRT.

The sensing transistor SENT may be turned on by the sense signal SENSE having the turn-on level voltage to transfer a reference voltage Vref supplied through the reference voltage line RVL to the second node N2 of the driving transistor DRT.

In addition, the sensing transistor SENT may be turned on by the sense signal SENSE having a turn-on level voltage to transfer a voltage of the second node N2 of the driving transistor DRT to the reference voltage line RVL.

Here, when the sensing transistor SENT is an N-type transistor, the turn-on level voltage of the sense signal SENSE may be a high level voltage. When the sensing transistor SENT is a P-type transistor, the turn-on level voltage of the sense signal SENSE may be a low level voltage.

The function of the sensing transistor SENT to transfer the voltage of the second node N2 of the driving transistor DRT to the reference voltage line RVL may be used in driving for sensing the characteristics of the subpixel SP. In this case, the voltage transferred to the reference voltage line RVL may be a voltage used to calculate the characteristics of the subpixel SP or a voltage on which the characteristics of the subpixel SP are reflected.

Each of the driving transistor DRT, the scan transistor SCT, and the sensing transistor SENT may be an N-type transistor or a P-type transistor. In the present disclosure, for the sake of brevity, each of the driving transistor DRT, the scan transistor SCT, and the sensing transistor SENT will be illustrated as being an N-type transistor.

The storage capacitor Cst may be an external capacitor intentionally designed to be provided externally of the driving transistor DRT, rather than a parasitic capacitor (e.g., Cgs or Cgd) such as an internal capacitor present between the gate node and the source node (or the drain node) of the driving transistor DRT.

The scan signal line SCL and the sense signal line SENL may be different gate lines GL. In this case, the scan signal SCAN and the sense signal SENSE may be different gate signals, the on-off timing of the scan transistor SCT in a single subpixel SP may be independent of the on-off timing of the sensing transistor SENT in the same subpixel SP. That is, the on-off timing of the scan transistor SCT and the on-off timing of the sensing transistor SENT in a single subpixel SP may be the same or different from each other.

Alternatively, the scan signal line SCL and the sense signal line SENL may be the same gate line GL. The gate node of the scan transistor SCT and the gate node of the sensing transistor SENT in a single subpixel SP may be connected to a single gate line GL. In this case, the scan signal SCAN and the sense signal SENSE may be the same gate signal, and the on-off timing of the scan transistor SCT and the on-off timing of the sensing transistor SENT in a single subpixel SP may be the same.

The structures of the subpixels SP illustrated in FIGS. 2 and 3 are for illustrative purposes only, and may be variously modified in forms by further including one or more transistors or one or more capacitors.

In addition, in FIGS. 2 and 3, the subpixel structures have been described by assuming that the display device 100 is a self-emissive display device. Alternatively, when the display device 100 is a liquid crystal display (LCD), each of the subpixels SP may include a transistor, a pixel electrode, and the like.

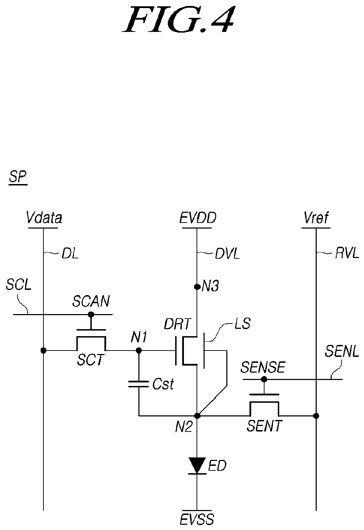

FIG. 4 is a diagram illustrating a light shield LS in a subpixel SP of the display device 100 according to an embodiment.

Referring to FIG. 4, in the subpixel SP of the display device 100 according to embodiments, the driving transistor DRT may have unique characteristics, such as a threshold voltage and mobility. When the unique characteristics of the driving transistor DRT change, the current driving performance (e.g., current supply performance) of the driving transistor DRT may also change, thereby changing the emission characteristics of the corresponding subpixel SP.

Device characteristics (e.g., threshold voltage and mobility) of the driving transistor DRT may change over the driving time of the driving transistor DRT. In addition, when the driving transistor DRT is illuminated with light, in particular, the channel area of the driving transistor DRT is illuminated with light, the device characteristics (e.g., threshold voltage and mobility) of the driving transistor DRT may change.

Thus, as illustrated in FIG. 4, in order to reduce changes in the device characteristics (e.g., changes in the threshold voltage or the mobility) of the driving transistor DRT, the light shield LS may be provided adjacent to the driving transistor DRT. For example, the light shield LS may be provided below the channel area of the driving transistor DRT.

The light shield LS may be provided below the channel area of the driving transistor DRT to serve as a body of the driving transistor DRT.

A body effect may occur in the driving transistor DRT. To reduce the influence of the body effect, the light shield LS serving as the body of the driving transistor DRT may be electrically connected to the second node N2 of the driving transistor DRT. Here, the second node N2 of the driving transistor DRT may be the source node of the driving transistor DRT.

Meanwhile, the light shield LS may be disposed below not only the channel area of the driving transistor DRT but also the channel area of another transistor (e.g., the scan transistor SCT or the sensing transistor SENT).

Hereinafter, a thin-film transistor structure allowing thin-film transistors disposed in the display panel 110 to have high performance, high stability, and high reliability will be described.

For example, in a process of forming thin-film transistors, when a gate insulating film or another electrode formed on a semiconductor layer in a position adjacent to a channel area of the semiconductor layer is etched, the semiconductor layer may be lost, damaged, or cut in the etching process. In this regard, the embodiments herein may provide a thin-film transistor structure for reducing the above-described risks in processing.

Here, the thin-film transistors having the thin-film transistor structure according to embodiments may be all or some of the thin-film transistors disposed in the display panel 110. In an example, the thin-film transistors having the thin-film transistor structure according to embodiments may include all or some of the transistors in each of the subpixels SP. In another example, the thin-film transistors having the thin-film transistor structure according to embodiments may include the entirety or some of the transistors in the GIP-type gate driver circuit 130.

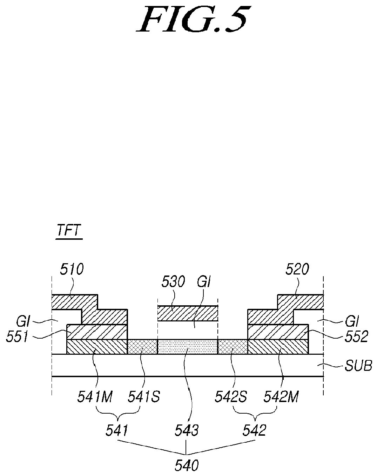

FIG. 5 is a cross-sectional diagram illustrating a vertical structure of a thin-film transistor TFT in the display device 100 according to one embodiment.

Referring to FIG. 5, the display panel 110 of the display device 100 according to embodiments may include a substrate SUB and a thin-film transistor TFT on the substrate SUB.

The substrate SUB may be a glass substrate, a plastic substrate, or the like. The substrate SUB may also be a flexible substrate, a bendable substrate, a stretchable substrate, or the like.

Referring to FIG. 5, the thin-film transistor TFT may include a first electrode 510, a second electrode 520, a third electrode 530, a semiconductor layer 540, and the like.

Referring to FIG. 5, the semiconductor layer 540 may include a channel portion 543, a first conductorized portion 541 positioned on one side (e.g., a first side) of the channel portion 543, and a second conductorized portion 542 positioned on another side (e.g., a second side) of the channel portion 543. For example, the semiconductor layer 540 may be an oxide semiconductor layer, and in some cases, a polycrystalline silicon semiconductor layer, an amorphous silicon semiconductor layer, or the like.

The first conductorized portion 541 may include a first main conductorized portion 541M and a first sub-conductorized portion 541S. The second conductorized portion 542 may include a second main conductorized portion 542M and a second sub-conductorized portion 542S.

Referring to FIG. 5, the thin-film transistor TFT may further include a gate insulating film GI on the channel portion 543.

Referring to FIG. 5, the thin-film transistor TFT may further include a first auxiliary electrode 551 and a second auxiliary electrode 552.

The first auxiliary electrode 551 may be positioned on the first main conductorized portion 541M among the first main conductorized portion 541M and the first sub-conductorized portion 541S of the first conductorized portion 541. As shown in FIG. 5, the first auxiliary electrode 551 is not on the first sub-conductorized portion 541S in one embodiment.

The first electrode 510 may be positioned on the first auxiliary electrode 551.

The second auxiliary electrode 552 may be positioned on the second main conductorized portion 542M among the second main conductorized portion 542M and the second sub-conductorized portion 542S of the second conductorized portion 542. As shown in FIG. 5, the second auxiliary electrode 552 is not on the second sub-conductorized portion 542S in one embodiment.

The second electrode 520 may be positioned on the second auxiliary electrode 552.

The third electrode 530 may be positioned on the gate insulating film GI and may overlap the channel portion 543.

Referring to FIG. 5, each of the first auxiliary electrode 551 and the second auxiliary electrode 552 may contain a conductive oxide. Here, the conductive oxide may be a conductive material containing oxygen.

For example, the conductive material may include at least one among a transparent conductive oxide (TCO), a nitrogen oxide, an organic matter, and the like.

For example, the TCO may include at least one among indium zinc oxide (IZO), an indium tin oxide (ITO), indium-gallium-zinc oxide (IGZO), zinc oxide (ZnO), aluminum-doped zinc oxide (AZO), gallium-doped zinc oxide (GZO), antimony tin oxide (ATO), flourine-doped transparent oxide (FTO), and the like.

For example, each of the first auxiliary electrode 551 and the second auxiliary electrode 552 may be a single auxiliary electrode layer or a plurality of auxiliary electrode layers. When each of the first auxiliary electrode 551 and the second auxiliary electrode 552 is a plurality of auxiliary electrode layers, the conductive oxide may include at least two among a TCO, a nitrogen oxide, an organic matter, and the like. At least two among the TCO, the nitrogen oxide, the organic matter, and the like of the conductive oxide may be contained in each of the plurality of auxiliary electrode layers.

Referring to FIG. 5, the first auxiliary electrode 551 is positioned on the first main conductorized portion 541M of the semiconductor layer 540, and the second auxiliary electrode 552 is positioned on the second main conductorized portion 542M of the semiconductor layer 540. Due to this configuration, damage to the first main conductorized portion 541M and the second main conductorized portion 542M of the semiconductor layer 540 can be prevented or at least reduced during the etching of the gate insulating film GI.

Referring to FIG. 5, the first auxiliary electrode 551 may be further disposed between the first conductorized portion 541 and the first electrode 510 such that the first conductorized portion 541 and the first electrode 510 are electrically connected through the first auxiliary electrode 551. Thus, the electrical connection between the first conductorized portion 541 and the first electrode 510 can be established and maintained in a reliable manner.

Likewise, the second auxiliary electrode 552 may be further disposed between the second conductorized portion 542 and the second electrode 520 such that the second conductorized portion 542 and the second electrode 520 are electrically connected through the second auxiliary electrode 552. Thus, the electrical connection between the second conductorized portion 542 and the second electrode 520 can be established and maintained in a reliable manner.

In addition, since the first auxiliary electrode 551 positioned between the first conductorized portion 541 and the first electrode 510 contains the conductive oxide, the possibility that defects may occur on the top surface of the semiconductor layer 540 can be significantly reduced.

When the first auxiliary electrode 551 is formed of a metal (e.g., Cu) instead of the conductive oxide, a portion of the metal may remain on the top surface of the semiconductor layer 540 or the top surface of the semiconductor layer 540 may degrade, thereby changing the channel characteristics of the semiconductor layer 540 or degrading the channel performance of the semiconductor layer 540. Consequently, device characteristics and reliability of the thin-film transistor TFT may degrade to some extent. However, when the first auxiliary electrode 551 is formed of the conductive oxide, defects on the top surface of the semiconductor layer 540 can be prevented or at least reduced, thereby improving the device characteristics and reliability of the thin-film transistor TFT.

In addition, since the second auxiliary electrode 552 positioned between the second conductorized portion 542 and the second electrode 520 contains the conductive oxide, the possibility that defects may occur on the top surface of the semiconductor layer 540 during the thin-film transistor fabrication can be significantly reduced.

When the second auxiliary electrode 552 is formed of a metal (e.g., Cu) instead of the conductive oxide, a portion of the metal may remain on the top surface of the semiconductor layer 540 or the top surface of the semiconductor layer 540 may degrade, thereby changing the channel characteristics of the semiconductor layer 540 or degrading the channel performance of the semiconductor layer 540. Consequently, the device characteristics and reliability of the thin-film transistor TFT may degrade to some extent. However, when the second auxiliary electrode 552 is formed of the conductive oxide, defects on the top surface of the semiconductor layer 540 can be prevented or at least reduced, thereby improving the device characteristics and reliability of the thin-film transistor TFT.

Referring to FIG. 5, the first sub-conductorized portion 541S may be positioned between the first main conductorized portion 541M and the channel portion 543. For example, the first sub-conductorized portion 541S may be a hydrogen conductorized portion.

The resistance of the first main conductorized portion 541M may be less than the resistance of the first sub-conductorized portion 541S. The resistance of the first sub-conductorized portion 541S may be less than the resistance of the channel portion 543.

Referring to FIG. 5, the second sub-conductorized portion 542S may be positioned between the second main conductorized portion 542M and the channel portion 543. For example, the second sub-conductorized portion 542S may be a hydrogen conductorized portion.

The resistance of the second main conductorized portion 542M may be less than the resistance of the second sub-conductorized portion 542S. The resistance of the second sub-conductorized portion 542S may be less than the resistance of the channel portion 543.

Referring to FIG. 5, the first sub-conductorized portion 541S may not overlap the first electrode 510 and the third electrode 530. That is, the first sub-conductorized portion 541S is non-overlapping with the first electrode 510 and the third electrode 530 in one embodiment.

The electric conductivity of the first sub-conductorized portion 541S may differ from the electric conductivity of the first main conductorized portion 541M.

For example, the electric conductivity of the first sub-conductorized portion 541S may be less than the electric conductivity of the first main conductorized portion 541M. The electric conductivity of the first sub-conductorized portion 541S may be greater than the electric conductivity of the channel portion 543.

Referring to FIG. 5, the second sub-conductorized portion 542S may not overlap the second electrode 520 and the third electrode 530. That is, the second sub-conductorized portion 542S is non-overlapping with the second electrode 520 and the third electrode 530 in one embodiment.

For example, the second sub-conductorized portion 542S and the second main conductorized portion 542M may have different electric conductivities. The electric conductivity of the second sub-conductorized portion 542S may be less than the electric conductivity of the second main conductorized portion 542M. The electric conductivity of the second sub-conductorized portion 542S may be greater than the electric conductivity of the channel portion 543.

The thin-film transistor TFT having the thin-film transistor structure illustrated in FIG. 5 may have a gate insulating film (GI) etch structure in which portions of the gate insulating film GI on the first sub-conductorized portion 541S and the second sub-conductorized portion 542S are etched or a GI etchless structure in which the gate insulating film GI on the first sub-conductorized portion 541S and the second sub-conductorized portion 542S is entirely unetched.

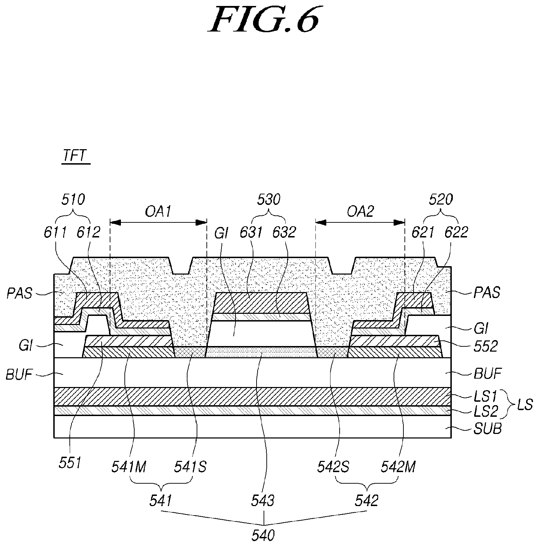

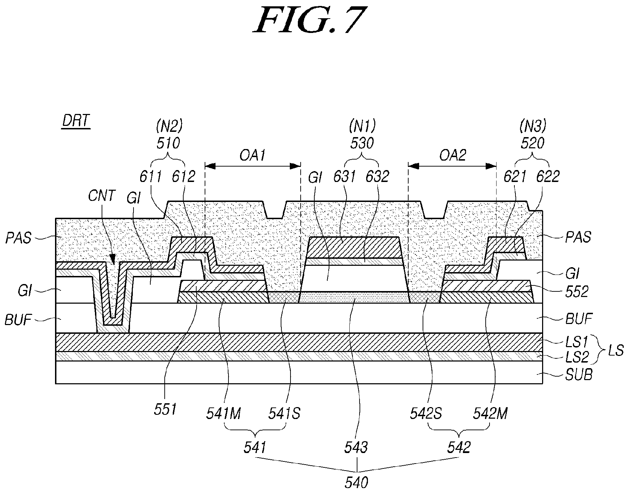

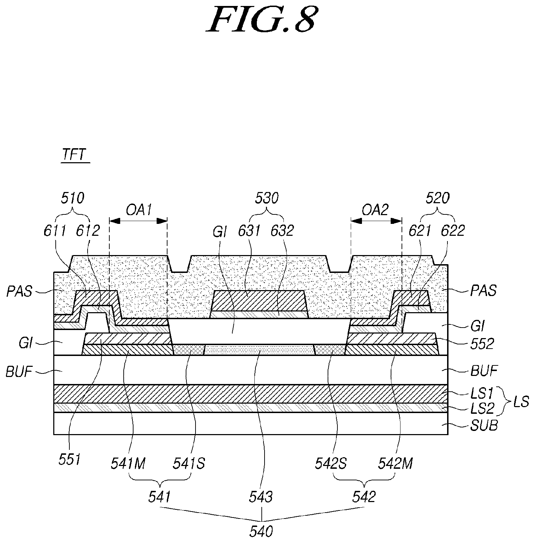

Hereinafter, the thin-film transistor TFT having the GI etch structure will be described with reference to FIGS. 6 and 7, and the thin-film transistor TFT having the GI etchless structure will be described with reference to FIGS. 8 to 10.

FIG. 6 is a cross-sectional diagram illustrating a thin-film transistor TFT having a GI etch structure in the display device 100 according to one embodiment, and FIG. 7 is a cross-sectional diagram illustrating a driving transistor DRT in which the thin-film transistor TFT illustrated in FIG. 6 is used in one embodiment.

Referring to FIG. 6, in the display device 100 according to embodiments, the thin-film transistor TFT having the GI etch structure may have the same structure as the thin-film transistor illustrated in FIG. 5.

In the thin-film transistor TFT having the GI etch structure in the display device 100 according to embodiments, each of the first electrode 510, the second electrode 520, and the third electrode 530 may be a single electrode layer, or at least one among the first electrode 510, the second electrode 520, and the third electrode 530 may be a multi-electrode layer.

When at least one among the first electrode 510, the second electrode 520, and the third electrode 530 is a multi-electrode layer, at least one among the first electrode 510, the second electrode 520, and the third electrode 530 may include a first material layer containing a first material and a second material layer containing a second material different from the first material.

Here, each of the first material and the second material may be a material different from the conductive oxide and does not contain oxygen. For example, the first material may include a metal, such as Cu, whereas the second material may include Mo, Ti, MoTi, or the like.

For example, the first electrode 510 may include a (1-1)th electrode layer 611 of the first material layer and a (1-2)th electrode layer 612 of the second material layer. The second electrode 520 may include a (2-1)th electrode layer 621 of the first material layer and a (2-2)th electrode layer 622 of the second material layer. The third electrode 530 may include a (3-1)th electrode layer 631 of the first material layer and a (3-2)th electrode layer 632 of the second material layer.

Referring to FIG. 6, the display panel 110 according to embodiments may include a passivation layer PAS disposed over the first electrode 510, the second electrode 520, the third electrode 530.

Referring to FIG. 6, the gate insulating film GI may include a first open area OA1 and a second open area OA2. In one embodiment, the first open area OA1 and the second open area OA2 are areas that lack the gate insulating film GI.

Referring to FIG. 6, the first electrode 510 and the first auxiliary electrode 551 may be electrically connected in the first open area OA1. The second electrode 520 and the second auxiliary electrode 552 may be electrically connected in the second open area OA2.

The thin-film transistor TFT illustrated in FIG. 6 may have a GI etch structure in which portions of the gate insulating film GI on the first sub-conductorized portion 541S and the second sub-conductorized portion 542S are etched to remove the portions of the gate insulating film GI in the first open area OA1 and the second open area OA2.

Thus, a first portion of the passivation layer PAS may be in contact with the first sub-conductorized portion 541S in the first open area OA1. A second portion of the passivation layer PAS may be in contact with the second sub-conductorized portion 542S in the second open area OA2.

In FIGS. 6 and 7, the passivation layer PAS may be a single layer or may include a multiple-layer film comprised of a plurality of layers having different hydrogen contents. The hydrogen content of at least one among the plurality of layers of the passivation layer PAS may be greater than the hydrogen content of each of the first sub-conductorized portion 541S and the second sub-conductorized portion 542S.

Referring to FIG. 6, in terms of processing sequence, after the first auxiliary electrode 551 and the second auxiliary electrode 552 are formed, the gate insulating film GI may be formed. After the gate insulating film GI is formed, the first electrode 510, the second electrode 520, and the third electrode 530 may be formed.

Referring to FIG. 6, the gate insulating film GI may be positioned on the top and side surfaces of a portion of the first auxiliary electrode 551. The gate insulating film GI may be positioned on the top and side surfaces of a portion of the second auxiliary electrode 552.

Referring to FIG. 6, the display panel 110 according to embodiments may further include a buffer layer BUF positioned below the semiconductor layer 540 and a light shield LS positioned below the buffer layer BUF.

The driving transistor DRT illustrated in FIGS. 2 and 3 having the thin-film transistor structure illustrated in FIG. 6 is configured as illustrated in FIG. 7.

Referring to FIG. 7, the first electrode 510 may correspond to the second node N2 of the driving transistor DRT, the second electrode 520 may correspond to the third node N3 of the driving transistor DRT, and the third electrode 530 may correspond to the first node N1 of the driving transistor DRT.

Referring to FIG. 7, the first electrode 510 may be electrically connected to the light shield LS through a contact hole CNT extending through the gate insulating film GI and the buffer layer BUF. Here, the first electrode 510 may correspond to the second node N2 of the driving transistor DRT. The second node N2 of the driving transistor DRT may be a source node or a drain node.

The light shield LS may be a single layer or a plurality of layers. When the light shield LS is comprised of a plurality of layers, the light shield LS may include a first light shield LS1 and a second light shield LS2. The second light shield LS2 may be positioned on the substrate SUB, whereas the first light shield LS1 may be positioned on the second light shield LS2. The buffer layer BUF may be positioned on the first light shield LS 1.

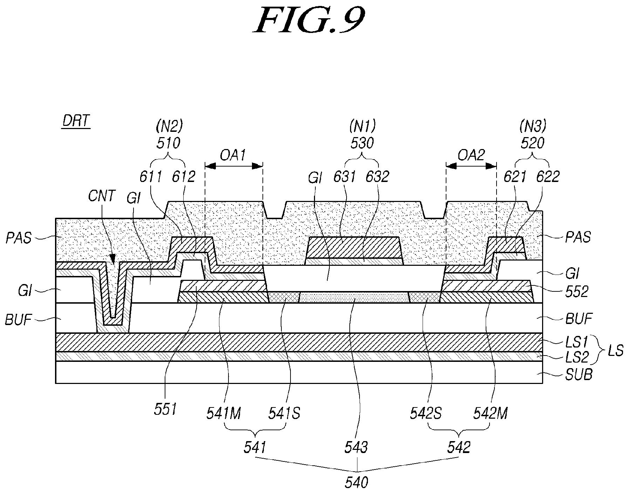

FIG. 8 is a cross-sectional diagram illustrating a thin-film transistor TFT having a GI etchless structure in the display device 100 according to one embodiment, and FIG. 9 is a cross-sectional diagram illustrating a driving transistor DRT in which the thin-film transistor TFT illustrated in FIG. 8 is used according to one embodiment.

Referring to FIG. 8, in the display device 100 according to embodiments, the thin-film transistor TFT having the GI etchless structure may have the same structure as the thin-film transistor illustrated in FIG. 5.

In the display device 100 according to embodiments, each of a first electrode 510, a second electrode 520, and a third electrode 530 in the thin-film transistor TFT having the GI etchless structure may be a single electrode layer. At least one among the first electrode 510, the second electrode 520, and the third electrode 530 may be comprised of a plurality of electrode layers.

When at least one among the first electrode 510, the second electrode 520, and the third electrode 530 is comprised of a plurality of electrode layers, at least one among the first electrode 510, the second electrode 520, and the third electrode 530 may include a first material layer containing a first material and a second material layer containing a second material different from the first material.

Here, each of the first material and the second material may be a material different from the conductive oxide and not containing oxygen. For example, the first material may include a metal, such as Cu, whereas the second material may include Mo, Ti, MoTi, or the like.

For example, the first electrode 510 may include a first electrode layer 611 of the first material layer and a first electrode layer 612 of the second material layer. The second electrode 520 may include a second electrode layer 621 of the first material layer and a second electrode layer 622 of the second material layer. The third electrode 530 may include a third electrode layer 631 of the first material layer and a third electrode layer 632 of the second material layer.

Referring to FIG. 8, the display panel 110 may further include a passivation layer PAS disposed on the first electrode 510, the second electrode 520, and the third electrode 530.

Referring to FIG. 8, a gate insulating film GI may have a first open area OA1 and a second open area OA2. In one embodiment, the first open area OA1 and the second open area OA2 are areas that lack the gate insulating film GI.

Referring to FIG. 8, the first electrode 510 and the first auxiliary electrode 551 may be electrically connected in a first open area OA1. The second electrode 520 and the second auxiliary electrode 552 may be electrically connected in a second open area OA2.

The thin-film transistor TFT illustrated in FIG. 8 may have the GI etchless structure in which portions of the gate insulating film GI on the first sub-conductorized portion 541S and the second sub-conductorized portion 542S are not etched.

Thus, the gate insulating film GI may be positioned on the first sub-conductorized portion 541S, and the gate insulating film GI may be positioned on the second sub-conductorized portion 542S such that the gate insulating film GI contacts the first sub-conductorized portion 541S and the second sub-conductorized portion 542S.

Accordingly, the first sub-conductorized portion 541S may be spaced apart from the passivation layer PAS by the gate insulating film GI, whereas the second sub-conductorized portion 542S may be spaced apart from the passivation layer PAS by the gate insulating film GI. That is, a first portion of the gate insulating film GI is between the first sub-conductorized portion 541S and a first portion of the passivation layer PAS, and a second portion of the gate insulating film GI is between the second sub-conductorized portion 542S and a second portion of the passivation layer PAS.

Referring to FIG. 8, the display panel 110 according to embodiments may further include a buffer layer BUF positioned below the semiconductor layer 540 and a light shield LS positioned below the buffer layer BUF.

Referring to FIG. 8, in terms of processing sequence, after the first auxiliary electrode 551 and the second auxiliary electrode 552 are formed, the gate insulating film GI may be formed. After the gate insulating film GI is formed, the first electrode 510, the second electrode 520, and the third electrode 530 may be formed.

Referring to FIG. 8, the gate insulating film GI may be positioned on the top and side surfaces of a portion of the first auxiliary electrode 551. The gate insulating film GI may be positioned on the top and side surfaces of a portion of the second auxiliary electrode 552.

The driving transistor DRT illustrated in FIGS. 2 and 3 having the thin-film transistor structure illustrated in FIG. 8 is as illustrated in FIG. 9.

Referring to FIG. 9, the first electrode 510 may correspond to the second node N2 of the driving transistor DRT, the second electrode 520 may correspond to the third node N3 of the driving transistor DRT, and the third electrode 530 may correspond to the first node N1 of the driving transistor DRT.

Referring to FIG. 9, the first electrode 510 may be electrically connected to the light shield LS through a contact hole CNT extending through the gate insulating film GI and the buffer layer BUF. Here, the first electrode 510 may correspond to the second node N2 of the driving transistor DRT. The second node N2 of the driving transistor DRT may be a source node or a drain node.

The light shield LS may be a single layer or a plurality of layers. When the light shield LS is comprised of a plurality of layers, the light shield LS may include a first light shield LS1 and a second light shield LS2. The second light shield LS2 may be positioned on the substrate SUB, whereas the first light shield LS1 may be positioned on the second light shield LS2. The buffer layer BUF may be positioned on the first light shield LS 1.

Referring to FIGS. 8 and 9, in the display panel 110 in which the thin-film transistors TFT having the GI etchless structure, at least a portion of the passivation layer PAS may contain hydrogen. Thus, at least a portion of the passivation layer PAS may disperse hydrogen into the first sub-conductorized portion 541S and the second sub-conductorized portion 542S.

Referring to FIGS. 8 and 9, in the display panel 110 in which the thin-film transistors TFT having the GI etchless structure, the hydrogen content of at least a portion of the passivation layer PAS may be greater than the hydrogen content of each of the first sub-conductorized portion 541S and the second sub-conductorized portion 542S.

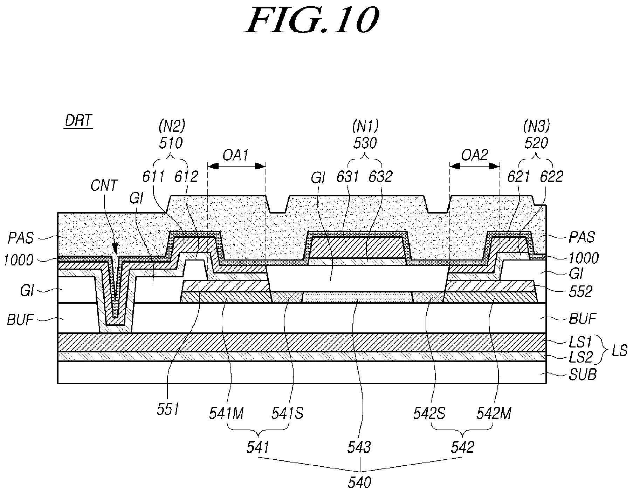

FIG. 10 is a cross-sectional view illustrating a thin-film transistor TFT having a GI etchless structure and a hydrogen supply structure in the display device 100 according to embodiments.

Referring to FIG. 10, the display panel 110 in which the thin-film transistors TFT having the GI etchless structure may further include a functional insulation layer 1000 containing hydrogen. The functional insulation layer 1000 is positioned between the passivation layer PAS and the first to third electrodes 510, 520 and 530. Thus, the functional insulation layer 1000 insulates the first to third electrodes 510, 520 and 530 from the passivation layer PAS.

In one embodiment, the functional insulation layer 1000 contains hydrogen, and may disperse hydrogen into the first sub-conductorized portion 541S and the second sub-conductorized portion 542S.

The hydrogen content of the functional insulation layer 1000 may be greater than the hydrogen content of each of the first sub-conductorized portion 541S and the second sub-conductorized portion 542S.

For example, the functional insulation layer 1000 may contain at least one among SiNx, SiON, and SiOx.

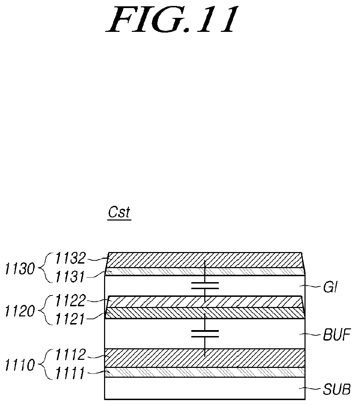

FIG. 11 is a cross-sectional view illustrating a capacitor structure of the display device 100 according to one embodiment.

Referring to FIG. 11, each of the subpixels SP may include a driving transistor DRT and a storage capacitor Cst.

The driving transistor DRT may be the thin-film transistor TFT illustrated in any of FIGS. 5 to 10 including the first electrode 510, the second electrode 520, the third electrode 530, and the semiconductor layer 540.

Referring to FIG. 11, the storage capacitor Cst may have a vertical structure corresponding to the vertical structure of the thin-film transistor TFT illustrated in any of FIGS. 5 to 10.

Referring to FIG. 11, the storage capacitor Cst may include a first plate 1110, a second plate 1120, and a third plate 1130 in one embodiment.

Referring to FIG. 11, the buffer layer BUF may be positioned between the first plate 1110 and the second plate 1120. The gate insulating film GI may be positioned between the second plate 1120 and the third plate 1130.

Referring to FIGS. 2 and 3 together with FIG. 11, the first plate 1110 of the storage capacitor Cst may be electrically connected to the first electrode 510 of the driving transistor DRT or integrated with the first electrode 510 of the driving transistor DRT.

Here, the first electrode 510 of the driving transistor DRT may correspond to the second node N2 of the driving transistor DRT.

Referring to FIGS. 2 and 3 together with FIG. 11, the third plate 1130 of the storage capacitor Cst may be electrically connected to the third electrode 530 of the driving transistor DRT or integrated with the third electrode 530 of the driving transistor DRT.

Here, the third electrode 530 of the driving transistor DRT may correspond to the first node N1 (e.g., gate node) of the driving transistor DRT.

As another example, the third plate 1130 of the storage capacitor Cst may be electrically connected to the first electrode 510 of the driving transistor DRT. Here, the first electrode 510 of the driving transistor DRT may correspond to the second node N2 (e.g., source node) of the driving transistor DRT.

Referring to FIG. 11, the first plate 1110 may be the light shield LS electrically connected to the first electrode 510 of the driving transistor DRT or include a metal that is contained in the light shield LS.

Referring to FIG. 11, the third plate 1130 may be the third electrode 530 or the first electrode 510, electrically connected to the third electrode 530 or the first electrode 510, or includes a metal positioned on the same layer as the third electrode 530 or the first electrode 510.

Referring to FIG. 11, the second plate 1120 may include a conductive semiconductor plate 1121 and a conductive oxide plate 1122.

The conductive semiconductor plate 1121 may include the same semiconductor material as the semiconductor material included in the semiconductor layer 540. The semiconductor material included in the conductive semiconductor plate 1121 may be in a conductive state or in a non-conductive state.

The conductive oxide plate 1122 may be a plate containing a conductive oxide.

Referring to FIG. 11, the first plate 1110 may include a first layer 1111 and a second layer 1112. The first layer 1111 may include or may be made of the same material as the second light shield LS2. The second layer 1112 may include or may be made of the same material as the first light shield LS1.

Referring to FIG. 11, the third plate 1130 may include a first layer 1131 and a second layer 1132. The first layer 1131 may include or may be made of the same material as the second material layer. The second layer 1132 may include or may be made of the same material as the first material layer.

The second plate 1120 of the storage capacitor Cst may be electrically connected to the third electrode 530 of the driving transistor DRT.

The first plate 1110 may be electrically connected to the pixel electrode PE.

The above-described thin-film transistor structure according to embodiments may have a structure in which the first auxiliary electrode 551 is positioned on the first main conductorized portion 541M of the semiconductor layer 540 and the second auxiliary electrode 552 is positioned on the second main conductorized portion 542M of the semiconductor layer 540. Thus, in the etching of the gate insulating film GI, the first and second conductorized portions 541 and 542 of the semiconductor layer 540 can be prevented from being damaged

The thin-film transistor structure according to embodiments may have a structure in which each of the first auxiliary electrode 551 and the second auxiliary electrode 552 is spaced part from a gate electrode 530 in a horizontal direction so that, even when an error occurs in the processing, neither the first auxiliary electrode 551 nor the second auxiliary electrode 552 overlaps the gate electrode 530. Thus, it is possible to prevent or at least reduce the first auxiliary electrode 551 or the second auxiliary electrode 552 from forming a parasitic capacitance with the gate electrode 530. It is also possible to prevent or at least reduce misalignment between the channel portion 543 of the semiconductor layer 540 and the gate electrode 530.

The thin-film transistor structure according to embodiments may have a structure in which each of the first auxiliary electrode 551 and the second auxiliary electrode 552 contains a conductive oxide. Thus, it is possible to significantly reduce possibility that the surface of the channel portion 543 of the semiconductor layer 540 may be contaminated or damaged by a metal in the process of forming the thin-film transistor.

As described above, the thin-film transistor TFT having the thin-film transistor structure according to embodiments can have reliable device characteristics and high device performance.

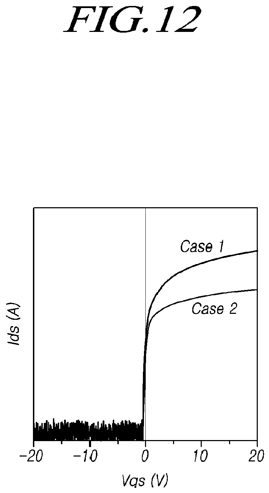

FIG. 12 is a graph illustrating electrical characteristics of the thin-film transistor TFT of the display device 100 according to embodiments, in which a drain current changes with changes in a gate voltage.

Referring to FIG. 12, the drain current according to changes in the gate voltage according to the thin-film transistor structure according to embodiments are illustrated.

Referring to FIG. 12, when a test for measuring a reference drain current having an intended level according to changes in a gate voltage was conducted for a situation in which the thin-film transistor structure according to embodiments is provided, the test was repeatedly performed for two cases, (e.g., Case 1 and Case 2). Case 1 refers to a case in which the drain-source voltage Vds of the thin-film transistor TFT is a high voltage (e.g., 10V), whereas Case 2 refers to a case in which the drain-source voltage Vds of the thin-film transistor TFT is a low voltage (e.g., 0.1V).

The above-described thin-film transistor TFT having the thin-film transistor structure according to embodiments may have reliable device characteristics and high device performance.

Referring to FIG. 12, in the thin-film transistor structure according to embodiments, the slope of the graph may be increased in an area in which the drain current Ids significantly changes in response to changes in the gate voltage Vgs regardless of Case 1 or 2.

That is, in the thin-film transistor structure according to embodiments, an S factor indicating the reciprocal of the slope may be reduced. Thus, switching characteristics (e.g., on-off characteristics) of the thin-film transistor TFT according to the gate voltage may be improved.

In the thin-film transistor structure according to embodiments, the threshold voltage of the thin-film transistor TFT can be reduced within a normal range, thereby improving device performance.

In the thin-film transistor structure according to embodiments, the mobility of the thin-film transistor TFT can be improved, thereby improving current driving performance of the thin-film transistor TFT.

The embodiments of the present disclosure set forth above will be briefly described as follows:

Embodiments may provide a display device including: a substrate; a semiconductor layer including a channel portion, a first conductorized portion positioned on one side of the channel portion and including a first main conductorized portion and a first sub-conductorized portion, and a second conductorized portion positioned on the other side of the channel portion and including a second main conductorized portion and a second sub-conductorized portion; a gate insulating film on the channel portion; a first auxiliary electrode positioned on the first main conductorized portion; a first electrode on the first auxiliary electrode; a second auxiliary electrode positioned on the second main conductorized portion; a second electrode on the second auxiliary electrode; and a third electrode positioned on the gate insulating film and overlapping the channel portion.

In the display device according to embodiments, each of the first auxiliary electrode and the second auxiliary electrode may include a conductive oxide. For example, the conductive oxide may include at least one among a transparent conductive oxide (TCO), a nitrogen oxide, and an organic matter.

The first sub-conductorized portion may be positioned between the first main conductorized portion and the channel portion. The second sub-conductorized portion may be positioned between the second main conductorized portion and the channel portion.

The resistance of the first main conductorized portion may be lower than the resistance of the first sub-conductorized portion. The resistance of the first sub-conductorized portion may be lower than the resistance of the channel portion.

The resistance of the second main conductorized portion may be lower than the resistance of the second sub-conductorized portion. The resistance of the second sub-conductorized portion may be lower than the resistance of the channel portion.

The first sub-conductorized portion may not overlap the first electrode or the third electrode. The electrical conductivity of the first sub-conductorized portion may differ from the electric conductivity of the first main conductorized portion.

The second sub-conductorized portion may not overlap the second electrode or the third electrode. The electrical conductivity of the second sub-conductorized portion may differ from the electrical conductivity of the second main conductorized portion.

At least one among the first electrode, the second electrode, and the third electrode may include a first material layer containing a first material and a second material layer containing a second material different from the first material.

Each of the first material and the second material may be different from the conductive oxide and may not contain oxygen.

The display device may further include a passivation layer disposed on the first electrode, the second electrode, and the third electrode.

The gate insulating film may include a first open area and a second open area.

The first electrode and the first auxiliary electrode may be electrically connected in the first open area. The second electrode and the second auxiliary electrode may be electrically connected in the second open area

According to embodiments, the display panel may have a GI etch structure.

In this case, a first portion of the passivation layer may be in contact with the first sub-conductorized portion in the first open area, and a second portion of the passivation layer may be in contact with the second sub-conductorized portion in the second open area.

According to embodiments, the display panel may have a GI etchless structure.

When the display panel according to embodiments has the GI etchless structure, the first sub-conductorized portion may be spaced apart from the passivation layer by the gate insulating film. The second sub-conductorized portion may be spaced apart from the passivation layer by the gate insulating film.

When the display panel according to embodiments has the GI etchless structure, at least a portion of the passivation layer may contain hydrogen, and may disperse the hydrogen into the first sub-conductorized portion and the second sub-conductorized portion.

The hydrogen content of at least a portion of the passivation layer may be higher than the hydrogen content of each of the first sub-conductorized portion and the second sub-conductorized portion.

When the display panel according to embodiments has the GI etchless structure, the passivation layer may include a plurality of layers having different hydrogen contents.

The hydrogen content of at least one among the plurality of layers of the passivation layer may be higher than the hydrogen content of each of the first sub-conductorized portion and the second sub-conductorized portion.

When the display panel according to embodiments has the GI etchless structure, the display device may further include a functional insulating film positioned between the first to third electrodes and the passivation layer and containing hydrogen.

The hydrogen content of the functional insulating film may be higher than the hydrogen content of each of the first sub-conductorized portion and the second sub-conductorized portion.

The display panel according to embodiments may further include: a buffer layer positioned below the semiconductor layer; and a light shield positioned below the buffer layer.

The first electrode may be electrically connected to the light shield through a contact hole extending through the gate insulating film and the buffer layer.

The display device according to embodiments may further include sub-pixels each including a driving transistor and a capacitor.

The driving transistor may be a thin-film transistor including the first electrode, the second electrode, the third electrode, and the semiconductor layer.

The capacitor may include a first plate, a second plate, and a third plate. The buffer layer may be positioned between the first plate and the second plate, and the gate insulating film is positioned between the second plate and the third plate.

The first plate may be electrically connected to the first electrode or the light shield, may be the light shield electrically connected to the first electrode, or may contain a metal contained in the light shield.

The third plate may be the third electrode, may be electrically connected to the third electrode, or may contain a metal positioned on the same layer as the third electrode.

The second plate may include a conductive semiconductor plate and a conductive oxide plate.

The conductive semiconductor plate may be a plate in which a semiconductor material the same as a semiconductor material contained in the semiconductor layer is conductorized.

The conductive oxide plate may contain the conductive oxide.

The first plate may be electrically connected to the pixel electrode.

Embodiments may provide a thin-film transistor array substrate including: a substrate; a semiconductor layer including a channel portion, a first conductorized portion positioned on one side of the channel portion and including a first main conductorized portion and a first sub-conductorized portion, and a second conductorized portion positioned on the other side of the channel portion and including a second main conductorized portion and a second sub-conductorized portion; a gate insulating film on the channel portion; a first auxiliary electrode positioned on the first main conductorized portion; a first electrode on the first auxiliary electrode; a second auxiliary electrode positioned on the second main conductorized portion; a second electrode on the second auxiliary electrode; and a third electrode positioned on the gate insulating film and overlapping the channel portion.

In the thin-film transistor array substrate according to embodiments, each of the first auxiliary electrode and the second auxiliary electrode may contain a conductive oxide. For example, the conductive oxide may contain at least one among a transparent conductive oxide, a nitrogen oxide, and an organic matter.

The thin-film transistor array substrate according to embodiments may further include a passivation layer disposed on the first electrode, the second electrode, and the third electrode.

The gate insulating film may include a first open area and a second open area.

The first electrode and the first auxiliary electrode may be electrically connected in the first open area, and the second electrode and the second auxiliary electrode are electrically connected in the second open area.

A first portion of the passivation layer may be in contact with the first sub-conductorized portion in the first open area. A second portion of the passivation layer may be in contact with the second sub-conductorized portion in the second open area.

In the case of the GI etchless structure, the first sub-conductorized portion may be spaced apart from the passivation layer by the gate insulating film. The second sub-conductorized portion may be spaced apart from the passivation layer by the gate insulating film.

The thin-film transistor array substrate having the GI etchless structure may further include a functional insulating film positioned between the first to third electrodes and the passivation layer and containing hydrogen.

According to embodiments as set forth above, it is possible to provide the thin-film transistor array substrate and the display device having the thin-film transistor structure capable of preventing the semiconductor layer from being damaged.

According to embodiments of the present disclosure, the thin-film transistor array substrate and the display device have the thin-film transistor structure capable of preventing the conductorized portion of the semiconductor layer from being damaged and preventing unnecessary parasitic capacitance from being generated.

According to embodiments of the present disclosure, the thin-film transistor array substrate and the display device have the thin-film transistor structure capable of preventing the conductorized portion of the semiconductor layer from being damaged and preventing a misalignment structure between a channel portion of the semiconductor layer and the gate electrode.

According to embodiments of the present disclosure, the thin-film transistor array substrate and the display device have the thin-film transistor structure capable of reducing the possibility of contamination or damage to the surface of the channel portion of the semiconductor layer during processing.

According to embodiments of the present disclosure, the thin-film transistor array substrate and the display device have the thin-film transistor structure by which high performance, high stability, and high reliability can be achieved.

The above description has been presented to enable any person skilled in the art to make and use the technical idea of the present invention, and has been provided in the context of a particular application and its requirements. Various modifications, additions and substitutions to the described embodiments will be readily apparent to those skilled in the art, and the general principles defined herein may be applied to other embodiments and applications without departing from the scope of the present invention. The above description and the accompanying drawings provide an example of the technical idea of the present invention for illustrative purposes only. That is, the disclosed embodiments are intended to illustrate the scope of the technical idea of the present invention. Thus, the scope of the present invention is not limited to the embodiments shown, but is to be accorded the widest scope consistent with the claims. The scope of protection of the present invention should be construed based on the following claims.

## Claims

1. A display device (100) comprising:
a substrate (SUB);
a semiconductor layer (540) comprising a channel portion (543), a first conductorized portion (541) positioned on a first side of the channel portion (543), and a second conductorized portion (542) positioned on a second side of the channel portion (543) that is opposite the first side, the first conductorized portion (541) including a first main conductorized portion (541M) and a first sub-conductorized portion (541S), and the second conductorized portion (542) including a second main conductorized portion (542M) and a second sub-conductorized portion (542S);
a gate insulating film (GI) on the channel portion (543);
a first auxiliary electrode (551) positioned on the first main conductorized portion (541M);
a first electrode (510) on the first auxiliary electrode (551);
a second auxiliary electrode (552) positioned on the second main conductorized portion (542M);
a second electrode (520) on the second auxiliary electrode (552); and
a third electrode (530) positioned on the gate insulating film (GI), the third electrode (530) overlapping the channel portion (543),
wherein each of the first auxiliary electrode (551) and the second auxiliary electrode (552) comprises a conductive oxide.

2. The display device (100) of claim 1, wherein the conductive oxide comprises at least one of a transparent conductive oxide, a nitrogen oxide, or an organic matter.

3. The display device (100) of claim 1 or 2, wherein the first sub-conductorized portion (541S) is positioned between the first main conductorized portion (541M) and the channel portion (543), and the second sub-conductorized portion (542S) is positioned between the second main conductorized portion (542M) and the channel portion (543),
a resistance of the first main conductorized portion (541M) is less than a resistance of the first sub-conductorized portion (541S), and the resistance of the first sub-conductorized portion (541S) is less than a resistance of the channel portion (543), and
a resistance of the second main conductorized portion (542M) is less than a resistance of the second sub-conductorized portion (542S), and the resistance of the second sub-conductorized portion (542S) is less than the resistance of the channel portion (543).

4. The display device (100) of any of claims 1 to 3, wherein the first sub-conductorized portion (541S) is non-overlapping with at least one of the first electrode (510) or the third electrode (530), and an electrical conductivity of the first sub-conductorized portion (541S) is different from an electric conductivity of the first main conductorized portion (541M), and
the second sub-conductorized portion (542S) is non-overlapping with at least one of the second electrode (520) or the third electrode (530), and an electrical conductivity of the second sub-conductorized portion (542S) is different from an electrical conductivity of the second main conductorized portion (542M).

5. The display device (100) of any of claims 1 to 4, wherein at least one among the first electrode (510), the second electrode (520), or the third electrode (530) comprises a first material layer and a second material layer, the first material layer including a first material and the second material layer including a second material that is different from the first material, and
each of the first material and the second material is different from the conductive oxide and lacks oxygen.

6. The display device (100) of any of claims 1 to 5, further comprising:
a passivation layer (PAS) disposed on the first electrode (510), the second electrode (520), and the third electrode (530),
wherein the gate insulating film (GI) comprises a first open area (OA1) that exposes the first sub-conductorized portion (541S) in the first open area (OA1) and a second open area (OA2) that exposes the second sub-conductorized portion (542S) in the second open area (OA2) such that a first portion of the passivation layer (PAS) is in contact with the first sub-conductorized portion (541S) in the first open area (OA1), and a second portion of the passivation layer (PAS) is in contact with the second sub-conductorized portion (542S) in the second open area (OA2),
wherein the first electrode (510) and the first auxiliary electrode (551) are electrically connected in the first open area (OA1), and the second electrode (520) and the second auxiliary electrode (552) are electrically connected in the second open area (OA2).

7. The display device (100) of any of claims 1 to 5, further comprising:
a passivation layer (PAS) disposed on the first electrode (510), the second electrode (520), and the third electrode (530),
wherein the gate insulating film (GI) comprises a first open area (OA1) and a second open area (OA2) such that the first electrode (510) and the first auxiliary electrode (551) are electrically connected in the first open area (OA1), and the second electrode (520) and the second auxiliary electrode (552) are electrically connected in the second open area (OA2), and
wherein the gate insulation film (GI) is between the first sub-conductorized portion (541S) and the passivation layer (PAS), and the gate insulation film (GI) is between the second sub-conductorized portion (542S) and the passivation layer (PAS).

8. The display device (100) of claim 7, wherein the passivation layer (PAS) comprises a plurality of layers, each layer of the plurality of layers having a different hydrogen content from other layers of the plurality of layers.

9. The display device (100) of claim 8, wherein the hydrogen content of at least one of the plurality of layers of the passivation layer (PAS) is greater than a hydrogen content of the first sub-conductorized portion (541S) and a hydrogen content of the second sub-conductorized portion (542S).

10. The display device (100) of any of claim 7 to 9, further comprising:
a functional insulating film positioned between the passivation layer (PAS) and the first electrode (510), the second electrode (520), and the third electrode (530), the functional insulating film comprising hydrogen.

11. The display device (100) of claim 10, wherein a hydrogen content of the functional insulating film is greater than a hydrogen content of the first sub-conductorized portion (541S) and a hydrogen content of the second sub-conductorized portion (542S).

12. The display device (100) of any of claims 1 to 11, further comprising:
a buffer layer (BUF) that is closer to the substrate (SUB) than the semiconductor layer (540); and
a light shield (LS) that is closer to the substrate (SUB) than the buffer layer (BUF),
wherein the first electrode (510) is electrically connected to the light shield (LS) through a contact hole (CNT) extending through the gate insulating film (GI) and the buffer layer (BUF).

13. The display device (100) of claim 12, further comprising:
a plurality of sub-pixels (SP), each sub-pixel (SP) comprising a driving transistor (DRT) and a capacitor (Cst),
wherein the driving transistor (DRT) is a thin-film transistor comprising the first electrode (510), the second electrode (520), the third electrode (530), and the semiconductor layer (540),
wherein the capacitor (Cst) comprises a first plate (1110), a second plate (1120), and a third plate (1130), and
the buffer layer (BUF) is positioned between the first plate (1110) and the second plate (1120), and the gate insulating film (GI) is positioned between the second plate (1120) and the third plate (1130).

14. The display device (100) of claim 13, wherein the first plate (1110) is electrically connected to the first electrode (510) or the light shield (LS), the first plate (1110) comprises the light shield (LS) that is electrically connected to the first electrode (510), or the first plate (1110) comprises a metal that is contained in the light shield (LS),
the third plate (1130) is the third electrode (530) or the first electrode (510), the third plate (1130) is electrically connected to the third electrode (530) or the first electrode (510), or the third plate (1130) comprises a metal positioned on the same layer as the third electrode (530) or the first electrode (510),
the second plate (1120) comprises a conductive semiconductor plate (1121) and a conductive oxide plate (1122), the conductive semiconductor plate (1121) including a semiconductor material that is the same as a semiconductor material included in the semiconductor layer (540), and the conductive oxide plate (1122) comprising the conductive oxide.
